# FASCICULE DE BREVET EUROPEEN

(11) **EP 4 222 783 B1**
(45) Date de publication et mention de la délivrance du brevet: **12.02.2025**
(21) Numéro de dépôt: 21786168.1
(22) Date de dépôt: 29.09.2021
(51) Int. Cl.: H01L 25/16, H01L 27/15, H01L 33/00, H01L 33/62

(54) **DISPOSITIF OPTOELECTRONIQUE**
OPTOELEKTRONISCHE VORRICHTUNG
OPTOELECTRONIC DEVICE

(30) Priorité: 30.09.2020 FR 2010001
(43) Date de publication de la demande: 09.08.2023
(73) Titulaire: Aledia, 38130 Echirolles (FR)
(72) Inventeur: ROBIN, Ivan-Christophe, 38000 Grenoble (FR); POURQUIER, Eric, 38000 Grenoble (FR); MOUREY, Bruno, 38500 Coublevie (FR)
(74) Mandataire: Cabinet Beaumont
(86) Numéro de dépôt international: PCT/EP2021/076727
(87) Numéro de publication internationale: WO 2022/069506

(56) Documents cités:
- EP-A1- 3 070 752
- WO-A1-2019/180362
- US-A1- 2015 362 165
- US-A1- 2017 133 550
- US-A1- 2017 179 097
- US-A1- 2018 358 339
- US-A1- 2019 139 949
- US-A1- 2019 165 231

## Description

### Domaine technique

La présente description concerne de façon générale un dispositif optoélectronique et son procédé de fabrication, par exemple un dispositif d'affichage d'images à diodes électroluminescentes et son procédé de fabrication.

### Technique antérieure

Il est connu de réaliser un dispositif optoélectronique comprenant au moins une diode électroluminescente et un circuit de commande de cette diode électroluminescente.

Le document US10468452 décrit un procédé de fabrication d'un tel dispositif comprenant la fabrication simultanée de plusieurs exemplaires du dispositif optoélectronique sur un même substrat et la séparation des dispositifs optoélectroniques ainsi fabriqués. Un inconvénient d'un tel procédé est qu'il comprend la formation d'électrodes recouvrant les flancs des dispositifs optoélectroniques, ce qui peut être une étape difficile à réaliser.

US2019/139949, US2019/165231, US2017/179097, US2015362165 et US2017/133550 décrivent un dispositif optoélectronique avec un empilement d'un circuit comprenant une diode électroluminescente et d'un circuit de commande de la diode électroluminescente. 1

WO2019180362 décrit un dispositif optoélectronique avec un empilement d'un circuit comprenant une diode électroluminescente et d'un circuit de commande de la diode électroluminescente, dans lequel une structure de connexion, comprenant la superposition d'une première et deuxième sous-couche diélectrique avec des plots de connexion, est située à l'interface entre les circuits.

### Résumé de l'invention

Il existe un besoin d'amélioration des dispositifs optoélectroniques et de leurs procédés de fabrication.

Un mode de réalisation pallie tout ou partie des inconvénients des dispositifs optoélectroniques connus et leurs procédés de fabrication.

L'invention prévoit un dispositif optoélectronique selon la revendication 1.

Selon un mode de réalisation, le dispositif comprend au moins deux connecteurs, situés sur le deuxième circuit, du côté opposé au premier circuit, destinés à relier électriquement le dispositif à un objet extérieur.

Selon un mode de réalisation, les premier et deuxième plots conducteurs sont séparés par ladite tranchée d'isolation électrique.

Selon un mode de réalisation, le deuxième circuit comprend des transistors à effet de champ à grille métal oxyde et comprend deux parties séparées électriquement par ladite tranchée d'isolation électrique.

Selon un mode de réalisation, les parties du deuxième circuit sont reliées électriquement par des connexions par des pistes conductrices électriquement situées du côté des transistors à effet de champ à grille métal oxyde opposé au premier circuit.

Selon un mode de réalisation, la tranchée d'isolation électrique a une forme fermée, dans un plan parallèle à la deuxième face.

Selon un mode de réalisation, la tranchée d'isolation électrique a, dans un plan parallèle à la deuxième face, une forme ouverte dont les deux extrémités libres débouchent sur un ou des côtés du dispositif.

Selon un mode de réalisation, le premier circuit comprend un substrat du côté de la première face.

Selon un mode de réalisation, le substrat est en saphir ou en verre.

Selon un mode de réalisation, la couche conductrice est en métal ou en un polymère conducteur.

Selon un mode de réalisation, la diode électroluminescente est de forme filaire ou de forme pyramidale.

Un mode de réalisation prévoit une structure comprenant une pluralité de dispositifs optoélectroniques tels que décrits ci-avant.

L'invention prévoit également un procédé de fabrication d'une pluralité de dispositifs optoélectroniques selon la revendication 9.

Selon un mode de réalisation, l'étape a) d'assemblage est réalisée par mise en contact, pleine plaque, des première et deuxième sous-couches de la couche conductrice électriquement.

Selon un mode de réalisation, chaque premier circuit est partiellement gravé dans une étape b) antérieure à l'étape a) de sorte à définir une première cavité située à l'emplacement de la deuxième électrode.

Selon un mode de réalisation, chaque premier circuit est partiellement gravé dans une étape b') antérieure à l'étape a) de faon à réaliser une deuxième cavité permettant de définir les bords de ladite diode électroluminescente.

Selon un mode de réalisation, le procédé comprend une étape c), entre les étapes a) et b) ou b'), dans laquelle chaque diode électroluminescente est recouverte, du côté de la deuxième face du premier circuit, d'une couche diélectrique ouverte au niveau des première et deuxième électrodes.

Selon un mode de réalisation, entre l'étape c) et l'étape a), chaque diode électroluminescente est recouverte, du côté de la deuxième face du premier circuit, de la première sous-couche conductrice.

Selon un mode de réalisation, chaque deuxième circuit est recouvert, avant l'étape a), de la deuxième sous-couche conductrice.

Selon un mode de réalisation, l'étape a) d'assemblage est réalisée par un collage non hybride de la première sous-couche conductrice avec la deuxième sous-couche conductrice.

Selon un mode de réalisation, l'étape a) est suivie d'une étape d) de gravure, pour chaque dispositif optoélectronique, d'une tranchée s'étendant dans la deuxième plaque et dans la couche conductrice électriquement jusqu'à la couche diélectrique.

Selon un mode de réalisation, l'étape d) est suivie d'une étape de remplissage de la tranchée en un matériau isolant afin de réaliser la tranchée d'isolation électrique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A illustre une vue en coupe, partielle et schématique, d'un mode de réalisation d'un dispositif optoélectronique ;
la figure 1B illustre une vue en coupe, partielle et schématique, d'une variante du dispositif optoélectronique représenté en figure 1A ;
la figure 2 illustre une vue de dessus, partielle et schématique, d'un mode de réalisation d'un dispositif optoélectronique ;
la figure 3 illustre une vue de dessus, partielle et schématique, d'un autre mode de réalisation d'un dispositif optoélectronique ;
la figure 4 illustre une étape d'un mode de mise en oeuvre d'un procédé de fabrication du dispositif illustré en figure 1A ou 1B ;
la figure 5 illustre une autre étape du procédé ;
la figure 6 illustre une autre étape du procédé ;
la figure 7 illustre une autre étape du procédé ;
la figure 8 illustre une autre étape du procédé ;
la figure 9 illustre une autre étape du procédé ;
la figure 10 illustre une autre étape du procédé ;
la figure 11 illustre une autre étape du procédé ;
la figure 12 illustre une autre étape du procédé ;
la figure 13 illustre une autre étape du procédé ;
la figure 14 est une vue de détail d'une partie de la figure 13 ;
la figure 15 illustre une autre étape du procédé ;
la figure 16 illustre une autre étape du procédé ;
la figure 17 illustre une étape d'un autre mode de mise en oeuvre d'un procédé de fabrication du dispositif illustré en figure 1A ou 1B ; et
la figure 18 illustre une autre étape du procédé.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits de commande des diodes électroluminescentes des dispositifs optoélectroniques n'ont été détaillés que brièvement.

Sauf précision contraire, lorsque l'on fait référence à deux éléments connectés entre eux, cela signifie directement connectés électriquement sans éléments intermédiaires autres que des conducteurs, et lorsque l'on fait référence à deux éléments reliés (en anglais "coupled") entre eux, cela signifie que ces deux éléments peuvent être connectés électriquement ou être reliés électriquement par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près. En outre, on considère ici que les termes "isolant" et "conducteur" signifient respectivement "isolant électriquement" et "conducteur électriquement".

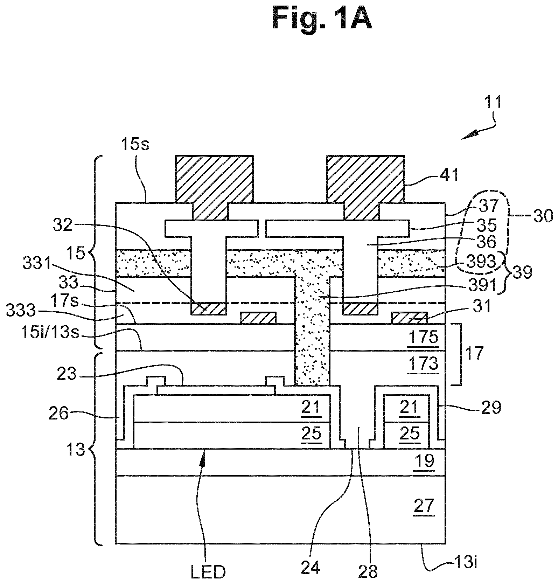

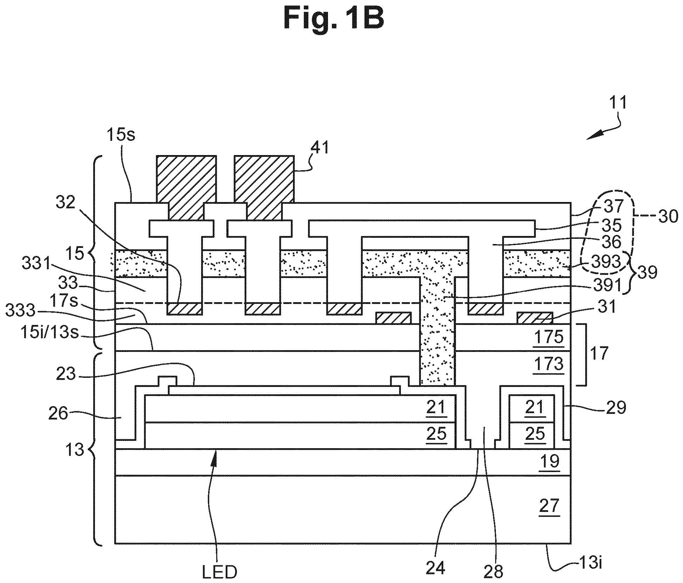

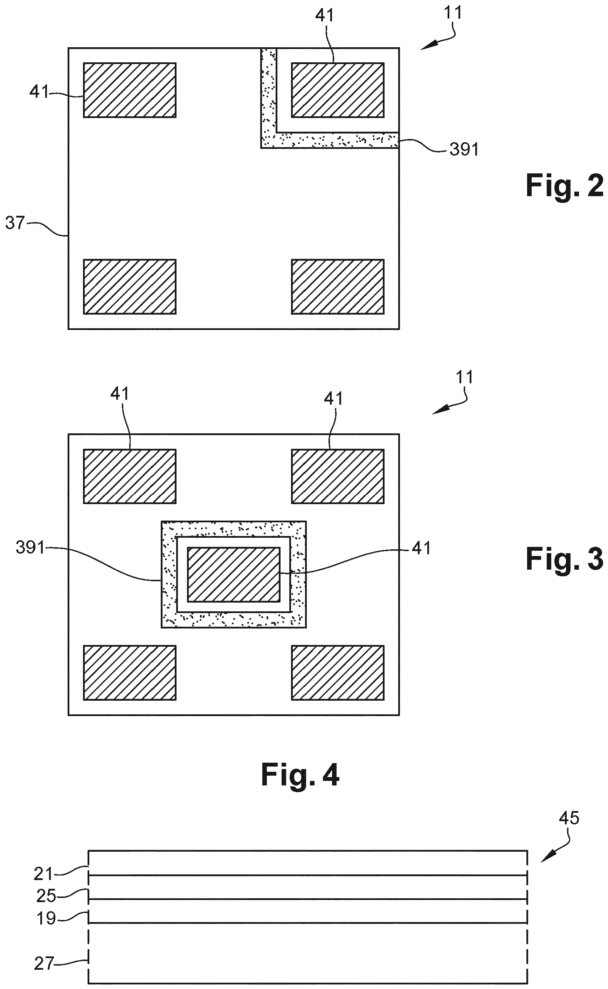

Les figures 1A représente une vue en coupe, partielle et schématique, d'un mode de réalisation d'un dispositif optoélectronique 11 et la figure 1B représente une vue en coupe d'une variante du dispositif optoélectronique 11 de la figure 1B. La figure 2 est une vue de dessus, partielle et schématique, du dispositif optoélectronique 11 de la figure 1A.

Sur les figures 1A et 1B, certains des éléments internes du dispositif 11 ont été représentés.

Le dispositif 11 comprend :
une première portion 13, appelée également circuit optoélectronique, comprenant au moins une diode électroluminescente LED inorganique émettant un rayonnement notamment en direction d'une face 13i inférieure de la première portion 13, la première portion 13 comprenant, en outre, une face supérieure 13s opposée à la face inférieure 13i ; et
une deuxième portion 15, appelée également circuit logique, comprenant un circuit de commande de la diode électroluminescente LED, et comprenant une face inférieure 15i et une face supérieure 15s opposée à la face inférieure 15i, la face inférieure 15i de la deuxième portion 15 étant sur la face supérieure 13s de la première portion 13.

Selon le mode de réalisation illustré sur les figures 1A et 1B, le dispositif 11 comprend, à l'interface entre le circuit optoélectronique 13 et le circuit logique 15, une couche 17 morcelée horizontalement, c'est-à-dire dans le plan de la face supérieure 13s, la couche 17 comprenant un empilement d'une première sous-couche 173 située dans le circuit optoélectronique 13 et d'une deuxième sous-couche 175 située dans le circuit logique 15. Comme cela est décrit plus en détail par la suite, la couche 17 est divisée en deux parties horizontalement dans l'orientation de la figure 1A, c'est-à-dire dans le plan de la face supérieure 13s.

La couche 17 est en un matériau conducteur, par exemple, un matériau métallique ou un polymère conducteur. La couche 17 est, de préférence, en titane, en aluminium, en nickel, en argent, en cuivre, en or ou en un alliage ou une combinaison de tout ou partie de ces matériaux.

La face supérieure de la sous-couche 173 correspond à la face supérieure 13s du circuit optoélectronique 13 et la face inférieure de la sous-couche 175 correspond à la face inférieure 15i du circuit logique 15.

La diode électroluminescente LED du circuit optoélectronique 13 comprend, selon le mode de réalisation illustré sur les figures 1A et 1B, au moins deux couches semiconductrices de types de conductivité opposés définissant, par exemple, une jonction PN.

La diode électroluminescente LED comprend ainsi une couche semiconductrice 19, d'un premier type de conductivité, par exemple de type N, et une couche semiconductrice 21, d'un deuxième type de conductivité, par exemple de type P, différent du premier type de conductivité. La couche 21 peut avoir une concentration de dopants comprise entre 10¹⁵ et 10²⁰ dopants/cm3 et avoir une épaisseur comprise entre 5 nm et 2 µm. La couche 19 peut avoir une concentration de dopants comprise entre 10¹⁷ et 10²⁰ dopants/cm3 et avoir une épaisseur comprise entre 50 nm et 2 µm. Les couches 19 et 21 sont, par exemple, en composé III-V ou en composé II-VI, par exemple en GaN (nitrure de gallium). Les couches 19 et 21 peuvent avoir chacune une structure monocouche ou une structure multicouche.

La diode électroluminescente LED du circuit optoélectronique 13 comprend, en outre, une couche active 25 située entre les couches 19 et 21. La couche active 25 est la couche dans laquelle se produisent l'essentiel des recombinaisons radiatives entrainant l'émission lumineuse de la diode électroluminescente LED. La couche active 25 a, par exemple, une structure de puits quantiques multiples.

Selon le mode de réalisation illustré sur les figures 1A et 1B, la couche 19 repose sur un substrat 27. Plus particulièrement, la couche 19 recouvre totalement la face supérieure du substrat 27. Le substrat 27 peut correspondre à un substrat de croissance du matériau composant la couche 19 et être, par exemple, en saphir. Le substrat 27 peut, en variante, correspondre à un substrat de report, par exemple un substrat de report en verre en remplacement d'un substrat de croissance en silicium. La couche 25 recouvre, de préférence, la couche 19 et la couche 25 est recouverte par la couche 21. La couche 17 recouvre la couche 21. Les bords latéraux des couches 21, 25 peuvent présenter un retrait 26 par rapport à la couche 19. Le dispositif 11 comprend en outre un via conducteur 28 traversant les couches 21, 25, isolé électriquement des couches 21, 25, et reliant électriquement la sous-couche 173 de la couche 17 à la couche 19. Selon un autre mode de réalisation, le via conducteur 28 est situé sur un bord des couches 21 et 25. La sous-couche 173 a, par exemple, une épaisseur supérieure à 1,5 µm. Sur les figures 1A et 1B, le via 28 est représenté s'arrêtant sur la face supérieure de la couche 19. A titre de variante, le via 28 peut pénétrer dans la couche 19 sur une partie de l'épaisseur de la couche 19.

Le circuit optoélectronique 13 comprend en outre une première électrode 23, par exemple l'anode de la LED, disposée sur et en contact avec la couche 21 et une deuxième électrode 24, par exemple la cathode de la LED, correspondant au contact entre le via 28 et la couche 19.

La première électrode 23 est, par exemple en un matériau métallique tel que le nickel, l'argent, l'or, l'aluminium, le cuivre, le titane ou un alliage ou une combinaison de tout ou partie de ces matériaux. La première électrode 23 a une épaisseur, par exemple, comprise entre 200 nm et 900 nm. La première électrode 23 peut avoir une structure monocouche ou multicouche.

Selon le mode de réalisation illustré sur les figures 1A et 1B, le circuit optoélectronique 13 comprend en outre une couche diélectrique 29. La couche diélectrique 29 recouvre, de préférence, le pourtour de la première électrode 23, une partie de la couche 21 non recouverte par la première électrode 23, les bords latéraux des couches 21, 25 au niveau du retrait 26 et du via 28, et la couche 19 au niveau du retrait 26 et seulement une partie de la couche 19 au niveau du via 28. La couche diélectrique 29 sert d'isolation électrique, mais également de passivation des bords latéraux de la couche active 25 qui peut notamment comprendre des puits quantiques.

La couche 29 a, par exemple, une épaisseur comprise entre 0,1 µm et 1 µm, et est en un matériau diélectrique tel que le nitrure de silicium ou le dioxyde de silicium ou une combinaison de ces deux matériaux.

Dans le mode de réalisation représenté sur les figures 1A et 1B, la diode électroluminescente a une structure dite planaire dans la mesure où elle correspond à un empilement de couches. Selon un autre mode de réalisation particulier, le circuit optoélectronique 13 peut comprendre une diode électroluminescente ou plusieurs diodes électroluminescentes tridimensionnelles, par exemple de forme filaire ou de forme pyramidale. En particulier, la diode électroluminescente LED peut comprendre un élément semiconducteur tridimensionnel, ou plusieurs éléments semiconducteurs tridimensionnels, par exemple des nanofils ou des microfils, chaque élément semiconducteur tridimensionnel étant du premier type de conductivité et étant recouvert d'une zone active, elle-même recouverte d'un élément semiconducteur du deuxième type de conductivité. L'électrode 23 peut être en contact avec les éléments semiconducteurs du deuxième type de conductivité, tandis que les éléments semiconducteurs du premier type de conductivité peuvent reposer sur une couche conductrice au contact du via 28.

Le circuit logique 15 comprend une zone 33, appelée circuit MOS, comprenant une première partie 331 comprenant un substrat dans et sur lequel sont formés des transistors à effet de champ à grille isolée aussi appelés transistors MOS. Le substrat peut correspondre à un substrat semiconducteur ou peut avoir une structure de type silicium sur isolant (SOI, Silicon On Insulator). Le circuit MOS 33 comprend en outre un premier réseau d'interconnexions 333 situé entre la première partie 331 et la couche 17 et comprenant un empilement de couches isolantes entre lesquelles et au travers desquelles sont disposés des pistes conductrices et des vias conducteurs. En particulier, le premier réseau d'interconnexions 333 comprend des plots conducteurs électriquement 31 et 32.

Le circuit logique 15 comprend, en outre, un deuxième réseau d'interconnexions 30, situé sur le circuit MOS 33, du côté du circuit MOS 33 opposé au circuit optoélectronique 13 et pouvant également s'étendre au travers du circuit MOS 33.

Les plots 32 sont destinés à relier électriquement le circuit MOS 33 et le réseau d'interconnexion 30. Les plots 31 sont destinés à être, chacun, relié électriquement à une électrode de la diode électroluminescente du circuit optoélectronique 13 par l'intermédiaire de la couche 17. Les plots conducteurs électriquement 31, 32 sont, de préférence, en titane, en aluminium, en argent, en nickel, en cuivre, en or ou en un alliage ou une combinaison de tout ou partie de ces matériaux.

Le dispositif 11 comprend en outre une structure d'isolation électrique 39 comportant :
une tranchée d'isolation électrique 391 permettant d'assurer une isolation électrique horizontale, c'est-à-dire une isolation dans un plan parallèle à la face 15i entre deux parties du circuit MOS 33 et entre deux parties de la couche 17 ; et
optionnellement, une couche isolante 393 recouvrant le circuit MOS 33 du côté du circuit MOS 33 opposé au circuit optoélectronique 13 et ayant la même composition que la tranchée d'isolation 391.

La couche d'isolation 393 est, de préférence, située dans le réseau d'interconnexions 30 à l'interface avec le circuit MOS 33. La couche 393 et la tranchée 391 peuvent avoir une structure multicouche ou monocouche. Tout ou partie de la couche 393 et de la tranchée 391 sont, de préférence, en un matériau diélectrique. A titre d'exemple, la tranchée d'isolation électrique 391 peut comprendre des parois isolantes électriquement et un coeur en un matériau de remplissage, par exemple un matériau conducteur ou semiconducteur. A des fins d'illustrations, la tranchée d'isolation 391 est représentée sur les figures 2 et 3.

La tranchée 391 s'étend de la face supérieure du circuit MOS 33 dans l'orientation de la figure 1A à travers le circuit MOS 33, et la couche 17 de façon à déboucher sur la couche diélectrique 29. La tranchée 391 peut être remplie d'un matériau ayant une structure multicouche ou monocouche. La tranchée 391 est, de préférence, remplie d'un matériau diélectrique.

De préférence, il y a au moins un plot 31 de chaque côté de la tranchée 391.

La tranchée 391 a, selon le mode de réalisation illustré en figure 2, une forme ouverte débouchant sur au moins un côté du dispositif 11, ici sur deux côtés du dispositif 11. La tranchée 391 isole notamment une portion latérale du circuit MOS 33 et une portion latérale de la couche conductrice 17 reliée à la deuxième électrode 24 de la diode électroluminescente. A titre d'exemple, dans l'orientation de la figure 2, la tranchée 391 est en forme de "L" et débouche sur le côté haut du dispositif 11 et sur le côté droit du dispositif 11.

Selon le mode de réalisation illustré sur les figures 1A et 1B, le réseau d'interconnexions 30 comprend un empilement de couches isolantes 37 recouvrant le circuit MOS 33 du côté du circuit MOS 33 opposé au circuit optoélectronique 13, dont la couche 393 lorsqu'elle est présente, dans lesquelles et au travers desquelles sont formées des éléments conducteurs, notamment des pistes conductrices 35 et des vias conducteurs 36. Selon un mode de réalisation, chaque via conducteur 36 peut être connecté à l'une des pistes du premier réseau d'interconnexions 333, par exemple à l'un des plots 32, et ainsi s'étendre au travers de la première partie 331.

Selon un mode de réalisation, il y a des éléments conducteurs 35, 36 de chaque côté de la tranchée d'isolation électrique 391. Ces éléments, de part et d'autre de la tranchée d'isolation électrique 391 peuvent être reliés électriquement, par exemple, par l'une des pistes conductrices 35, comme cela est représenté sur la figure 1B.

Selon le mode de réalisation illustré sur les figures 1A et 1B, le circuit logique 15 comprend, en outre, des connecteurs 41 dont au moins l'un des connecteurs 41 est relié à la première électrode 23 et au moins un autre des connecteurs 41 est relié à la couche 19.

A titre d'exemple, les connecteurs 41 sont en titane, en aluminium, en argent, en nickel, en cuivre, en or, en étain, en alliage étain-argent, ou en un alliage ou une combinaison de tout ou partie de ces matériaux.

Selon le mode de réalisation représenté sur la figure 1A, les connecteurs 41 peuvent être situés de part et d'autre de la tranchée d'isolation 391. Toutefois, la position des connecteurs 41 ne dépend pas de la position de la tranchée d'isolation électrique 391, les connecteurs 41 n'étant pas en particulier nécessairement alignés avec les vias conducteurs 36, de sorte que les connecteurs 41 peuvent être situés du même côté de la tranchée d'isolation 391 comme cela est représenté en figure 1B. Les conducteurs électriques 35 peuvent par exemple relier un connecteur 41 disposé d'un côté de la tranchée d'isolation 391 et un via conducteur 36 disposé de l'autre côté de la tranchée 391. En outre, comme illustré sur la figure 1B, un conducteur électrique 35 peut relier électriquement deux vias conducteurs 36 disposés de part et d'autre de la tranchée d'isolation 391 et relier électriquement des plots 32 du premier réseau d'interconnexions 333 du circuit MOS 33. Les pistes conductrices 35 peuvent jouer le rôle d'une couche de redistribution, également appelée RDL (sigle anglais pour ReDistribution Layer), c'est-à-dire correspondre à une couche métallique supplémentaire recouvrant le circuit MOS 33 qui relie électriquement les connecteurs 41 à d'autres emplacements du circuit MOS 33, notamment pour libérer les contraintes de positionnement des connecteurs 41. Les pistes conductrices 35 permettent notamment de relier électriquement un connecteur 41, situé sur la partie du circuit MOS 33 située d'un côté de la tranchée 391, à la partie du circuit MOS 33 située de l'autre côté de la tranchée 391.

Selon un mode de réalisation, non représenté, le circuit MOS 33 ne comprend des transistors que d'un seul côté de la tranchée d'isolation 391. Le plot 31 situé dans la partie du circuit MOS 33 ne comprenant pas de transistor est alors relié au deuxième réseau d'interconnexions 30 sans connexion intermédiaire par des transistors MOS.

La figure 3 illustre, par une vue de dessus, une variante du dispositif 11 illustré en figure 2.

Selon le mode de réalisation illustré en figure 3, la tranchée 391 suit, en vue de dessus, une courbe fermée, et a ainsi une forme annulaire isolant notamment un îlot central du circuit MOS 33 et un îlot central de la couche conductrice 17 relié à la deuxième électrode 24 de la diode électroluminescente.

Les figures 4 à 16 illustrent des étapes d'un mode de mise en oeuvre d'un procédé de fabrication du dispositif 11 illustré sur les figures 1A et 1B.

Les figures 4 à 7 sont chacune des vues en coupe, partielles et schématiques, de structures obtenues à des étapes successives d'un mode de mise en oeuvre du procédé de fabrication d'une plaquette comprenant plusieurs exemplaires du circuit optoélectronique 13 illustré sur les figures 1A et/ou 1B.

La figure 4 illustre une structure 45 de départ à partir de laquelle plusieurs dispositifs 11 sont réalisés.

La structure 45 comprend, de bas en haut, dans l'orientation de la figure 4 :
le substrat 27 ;
la couche 19 ;
la couche 25 active ; et
la couche 21.

Le substrat 27 correspond, par exemple, à une plaquette semiconductrice (wafer) circulaire ayant un diamètre de préférence de l'ordre de 150 mm, 200 nm ou 300 nm. Les couches 19, 25, 21 sont toutes formées pleine plaque de façon à recouvrir sensiblement la totalité de la surface supérieure du substrat 27.

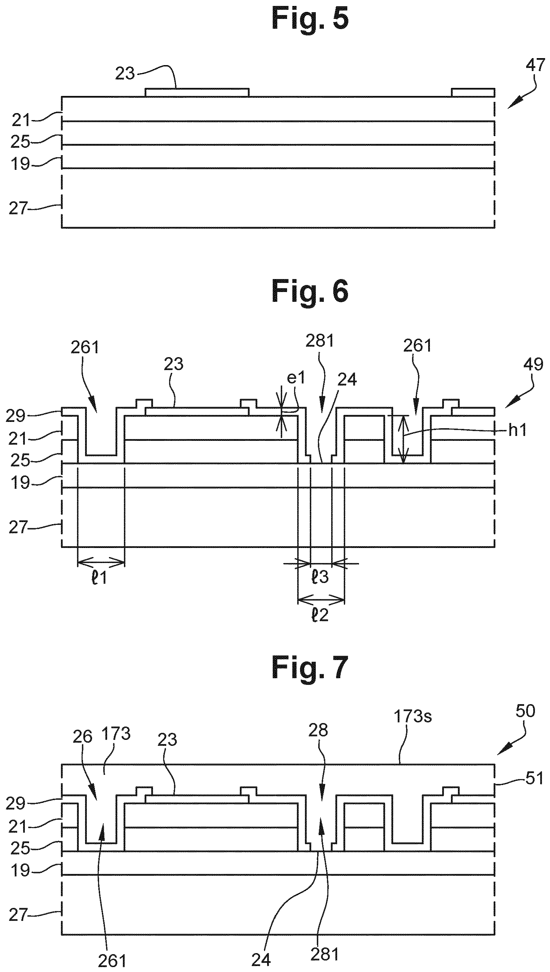

La figure 5 illustre une structure 47 obtenue à l'issue de la formation, pour chaque dispositif 11, de la première électrode 23 sur la face supérieure de la structure 45 illustrée en figure 4.

Le matériau constituant la première électrode 23 est déposé, par exemple, pleine plaque avant d'être gravé afin de ne conserver, pour chaque dispositif 11, la première électrode 23 que dans la zone souhaitée. L'électrode 23 est, par exemple, réalisée par la technique du décollage (lift-off) consistant au dépôt d'une couche de résine, à la formation de motifs dans la couche de résine, puis à un dépôt d'une couche métallique sur l'ensemble de la structure et notamment les motifs de résine. La résine est ensuite dissoute dans un solvant en emportant les portions de métal recouvrant les motifs de résine. Le dépôt métallique est, par exemple, réalisé par dépôt physique par phase vapeur (PVD, Physical vapor deposition) ou par dépôt chimique par phase vapeur (CVD, Chemical Vapor Deposition).

La figure 6 illustre une structure 49 obtenue à l'issue d'une étape de gravure et de dépôt de la couche isolante 29 sur la face supérieure de la structure 47 illustrée en figure 5.

La structure 47 est, lors de l'étape illustrée en figure 6, gravée de façon à former, pour chaque dispositif 11, des ouvertures 261, 281 sur une hauteur h1, supérieure ou égale à la somme des épaisseurs des couches 21 et 25, par exemple, de l'ordre de 0,5 µm. Lors de cette étape de gravure, une partie de la couche 19 en vis-à-vis des ouvertures 261 et 281 peut être gravée en plus des couches 21 et 25. Seules deux ouvertures 261 et une ouverture 281 ont été représentées en figure 6. Les ouvertures 261 sont situées aux emplacements auxquels une opération de découpe des dispositifs 11 va être réalisée à une étape ultérieure. Les ouvertures 281 sont situées aux emplacements des vias 28.

Les ouvertures 261 ont, par exemple, une largeur l1 de l'ordre de 50 µm et les ouvertures 281 ont, par exemple, une largeur l2 de l'ordre de 10 µm dans le plan de coupe de la figure 6.

La couche isolante 29 est, de préférence, déposée à la surface de la structure obtenue à l'issue de la gravure des ouvertures 261, 281 de sorte que la couche 29 recouvre la face supérieure de la couche 21, la face supérieure des électrodes 23, les bords latéraux des ouvertures 261, 281 et le fond des ouvertures 261, 281. L'épaisseur de la couche 29 est par exemple de l'ordre de 1 µm.

La couche isolante 29 est, par la suite gravée, par exemple par gravure humide ou sèche, afin de découvrir, pour chaque dispositif 11, une partie de l'électrode 23 et une partie de la couche 19. La gravure permet de découvrir la couche 19 dans les ouvertures 281 sur une largeur l3, par exemple, de l'ordre de 5 µm, dans le plan de coupe de la figure 6.

La figure 7 illustre une structure 50 obtenue à l'issue d'une étape de dépôt d'une couche conductrice 51 sur la face supérieure de la structure 49 illustrée en figure 6 de façon à former la sous-couche conductrice 173 et les vias 28. Une plaquette comprenant plusieurs exemplaires du circuit optoélectronique 13 est ainsi obtenue.

La couche conductrice 51 est, de préférence, déposée sur la totalité de la face supérieure de la structure 49 de sorte que la couche conductrice 51 recouvre la couche isolante 29, vienne au contact des électrodes 23 et vienne au contact de la couche semiconductrice 19 dans les ouvertures 281. La couche conductrice 51 s'étend, en outre, dans les ouvertures 261.

A l'issue de l'étape de dépôt de la couche conductrice 51, la structure est, optionnellement planarisée par un polissage mécano-chimique (CMP, Chemical Mechanical Planarization).

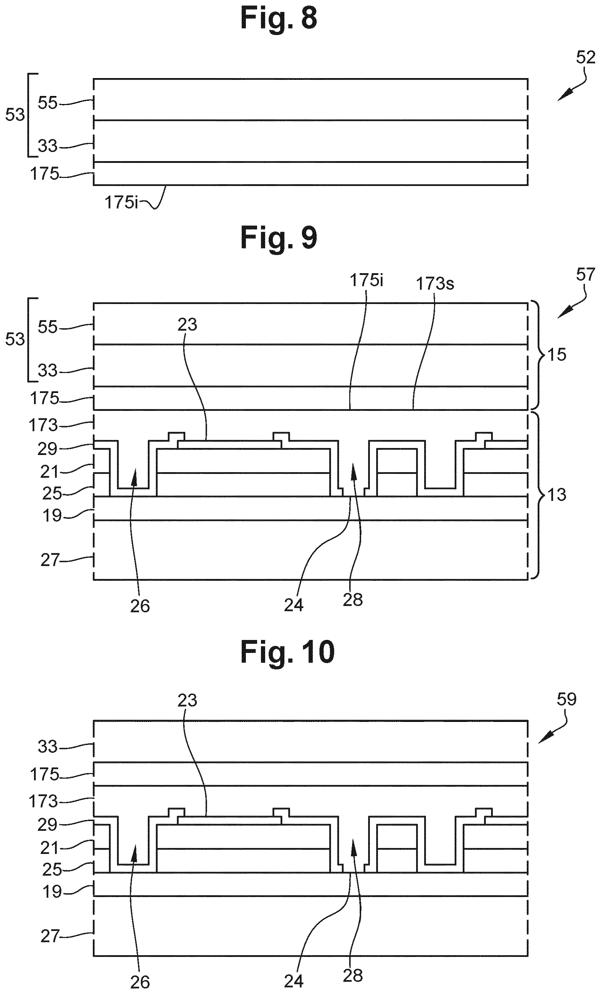

La figure 8 illustre une structure 52 comprenant, de haut en bas dans l'orientation de la figure 8 :
un substrat 53 ; et
la sous-couche 175.

Le substrat 53 comprend, de préférence, plusieurs exemplaires du circuit MOS 33 et une zone 55 vierge de tous composants électroniques.

Le substrat 53 est, par exemple, une plaquette semiconductrice sur et dans laquelle des composants électroniques ont été formés. Le substrat 53 a, de préférence, un diamètre de l'ordre de 100 mm, 200 mm ou 300 mm. Les circuits MOS 33 forment la partie inférieure du substrat 53, dans l'orientation de la figure 8 et la zone 55 est la partie supérieure du substrat 53, dans l'orientation de la figure 8.

La sous-couche 175 a, par exemple, une épaisseur supérieure à 500 nm.

Optionnellement, afin de planariser la face inférieure de la structure 52 et, plus précisément, de la sous-couche 175, celle-ci peut subir un polissage mécano-chimique CMP.

La figure 9 illustre une structure 57 obtenue à l'issue d'une étape d'assemblage de la structure 50 illustrée en figure 7 et de la structure 52 illustrée en figure 8.

La structure 52 est reportée sur la face supérieure de la structure 50. Plus précisément, une face inférieure 175i de la sous-couche 175 de la structure 52 est reportée sur une face supérieure 173s de la sous-couche 173 de la structure 50. L'étape de report de la structure 52 sur la structure 50 comprend, de préférence, une sous-étape d'alignement afin que les circuits MOS 33 soient alignés avec les ouvertures 261.

Selon un mode de réalisation, l'adhésion des sous-couches 173 et 175 est réalisée par collage conducteur nonhybride, c'est-à-dire que les faces des sous-couches entrant en contact sont planes, continues et formées d'un unique matériau. Les matériaux composant les deux sous-couches sont identiques. Ainsi, 173 et 175 adhèrent l'une à l'autre, sans matériau de collage.

La figure 10 illustre une structure 59 obtenue à l'issue d'une étape d'amincissement de la structure 57 illustrée en figure 9.

L'amincissement de la structure 57 illustrée en figure 9 est réalisé par sa face supérieure de sorte à retirer la zone 55 du substrat 53 et ne conserver dans le substrat 53 que les circuits MOS 33.

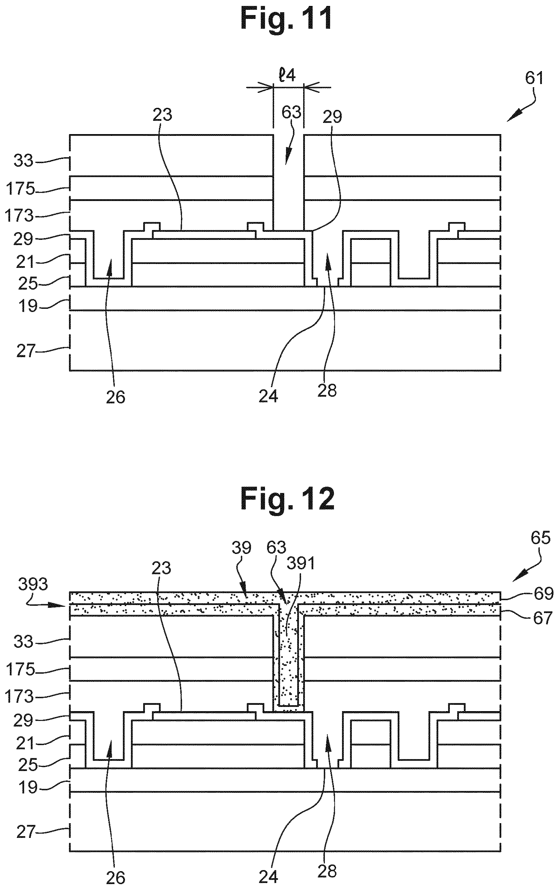

La figure 11 illustre une structure 61 obtenue à l'issue d'une étape de formation de tranchées 63 dans la structure 59 illustrée en figure 10, une seule tranchée 63 étant représentée en figure 11.

Les tranchées 63 s'étendent, de préférence, de la face supérieure de la structure 61 dans les circuits MOS 33, la sous-couche 175 et la sous-couche 173 de façon à découvrir la face supérieure de la couche isolante 29.

Les tranchées 63 sont, de préférence, réalisées par une succession de deux gravures sèches ou humides, l'une permettant de graver les différentes couches du circuit MOS 33 et l'autre permettant de graver les sous-couches 173 et 175. La couche isolante 29 peut jouer le rôle de couche d'arrêt de gravure lors de la formation des tranchées 63.

De préférence, une unique tranchée 63 est réalisée par dispositif 11, c'est-à-dire que chaque ouverture 261 entoure une unique tranchée 63. Chaque tranchée 63 est destinée à devenir une tranchée d'isolation 391 telle que représentée sur les figures 1A, 1B et 2. Les tranchées 63 ont donc la même forme que les tranchées d'isolation 391.

Les tranchées 63 ont, de préférence, une largeur l4 de l'ordre de 5 µm dans le plan de coupe de la figure 11.

La figure 12 illustre une structure 65 obtenue à l'issue d'une étape de formation de la structure d'isolation 39 sur la face supérieure de la structure 61 et dans les tranchées 63.

La structure d'isolation 39 comprenant la couche d'isolation 393 et les tranchées d'isolation 391 est réalisée, de préférence, par le dépôt successif de deux couches 67 et 69. La couche 67 est une couche isolante et est, par exemple, déposée sur la face supérieure de la structure 61 illustrée en figure 11 de sorte que la couche 67 recouvre la face supérieure des circuits MOS 33 et les faces latérales et le fond des ouvertures 63. La couche 67 est, de préférence, conforme et déposée par une technique de dépôt en phase vapeur.

La couche 69 est, de préférence, déposée de façon à couvrir intégralement la couche 67. La couche 69 vient, par exemple, combler la tranchée 39. La couche 69 peut être une couche isolante ou une couche d'un matériau de remplissage, par exemple du silicium polycristallin.

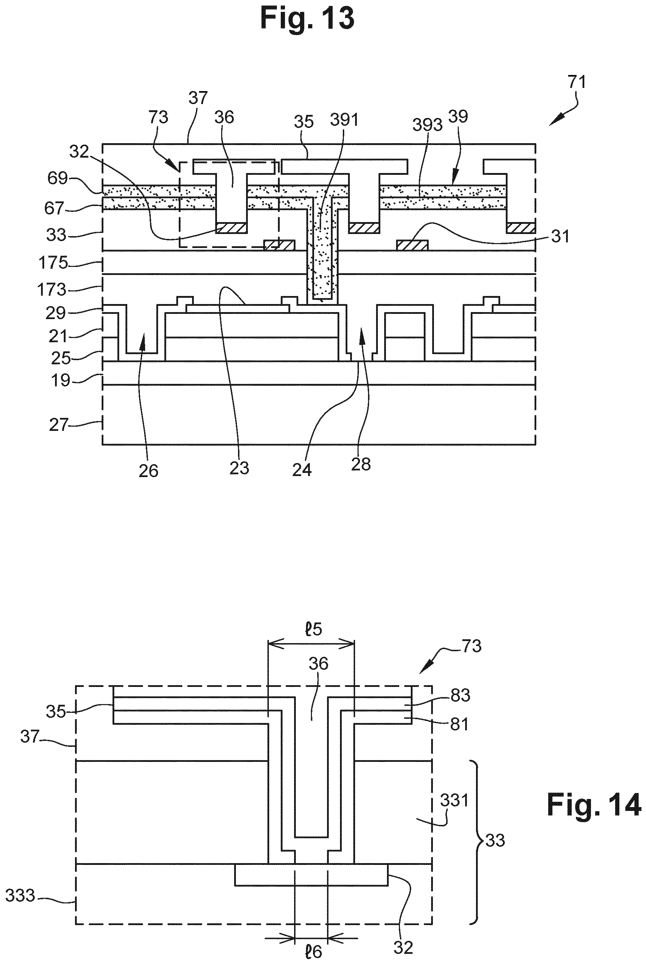

La figure 13 illustre une structure 71 obtenue à l'issue d'une étape de formation, pour chaque dispositif 11, de l'empilement des couches isolantes 37, des pistes conductrices 35 et des vias conducteurs 36 sur et dans la structure 65 illustrée en figure 12. La figure 13 illustre de façon très schématique la connexion électronique des pistes 35 à un ou des niveaux de métallisations du circuit MOS 33, schématisés en figure 13 par les plots 32, et ce par les vias 36. La figure 14 est un agrandissement d'une partie 73 de la structure 71.

Selon un mode de réalisation, le plot 32 correspond à une piste de l'un quelconque des niveaux de métallisation du circuit MOS 33, de préférence, le premier niveau. Afin d'atteindre la piste 32, chaque vias 36 traverse, par exemple :
la couche 37 ; et
la première partie 331 du circuit MOS 33.

La réalisation des vias 36 comprend de préférence, une étape de gravure permettant de graver la partie 331 du circuit MOS 33 sur une épaisseur comprise entre 3 µm et 5 µm. Les vias 36 ont, de préférence, chacun une largeur l5 supérieure à 6 µm. A la suite de l'étape de gravure, le dépôt d'une couche isolante 81, par exemple en dioxyde de silicium, est réalisé par exemple par une technique de dépôt chimique en phase vapeur assisté par plasma (PECVD, Plasma-Enhanced Chemical Vapor Deposition). La couche 81 a, de préférence, une épaisseur de l'ordre de 0,5 µm. A la suite de l'étape de dépôt de la couche 81, celle-ci est gravée de sorte à faire apparaître une partie de la face supérieure des plots 32 (ou d'un plot 31 dans l'éventualité où le circuit MOS 33 ne comporte pas de transistor d'un côté de la tranchée d'isolation 391), au fond des ouvertures formées dans le circuit MOS 33. La gravure de la couche 81 permet de découvrir les plots 32 sur une largeur l6 supérieure à 3 µm. A la suite de l'étape de gravure de la couche 81, il est déposé une couche métallique 83, par exemple, en aluminium, tungstène, cuivre ou une combinaison ou un alliage de ces deux matériaux. La couche 83 est, de préférence, déposée par une technique de dépôt physique en phase vapeur. La couche 83 recouvre ainsi la couche 81 et vient au contact des plots 32. La couche 83 a, de préférence, une épaisseur de l'ordre de 1 µm. La couche 83 est, par la suite, gravée afin de la conserver afin de former uniquement les vias 36 et éventuellement les pistes conductrices 35 telles qu'illustrées en figure 13.

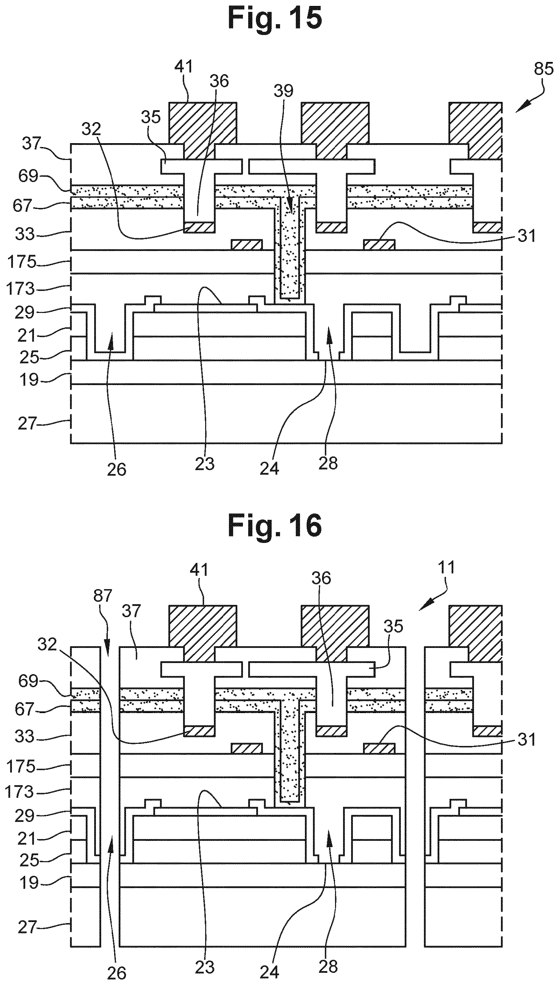

La figure 15 illustre une structure 85 obtenue à l'issue d'une étape de formation des connecteurs 41 sur la face supérieure de la structure 71 illustrée en figure 13.

Les connecteurs 41 sont formés au contact de pistes 35. De préférence, pour chaque dispositif, au moins un connecteur 41 est relié à l'électrode 23 et au moins un connecteur 41 est relié à la couche 19.

La figure 16 illustre une pluralité de dispositifs 11 obtenue à l'issue d'une étape de découpe, de la structure 85 illustrée en figure 15.

La structure 85 illustrée en figure 15 est, par exemple, sciée de façon à réaliser des tranchées 87 au moyen d'une lame ayant une épaisseur, par exemple, de l'ordre de 40 µm.

Les tranchées 87 sont traversantes et permettent de découper la structure 85 en dispositifs 11 unitaires. Les tranchées 87 s'étendent, par exemple, dans le circuit logique 15 et dans le circuit optoélectronique 13 dans les ouvertures 261. L'étape de sciage de la structure 85 peut être précédée d'une étape d'amincissement du substrat 27 sur une épaisseur de l'ordre de 300 µm.

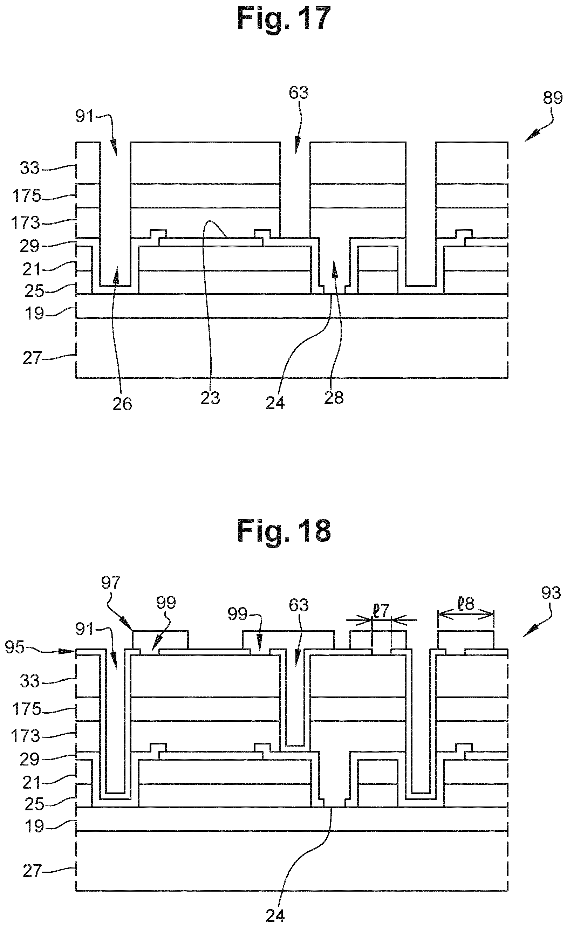

Les figures 17 et 18 sont des vues en coupe, partielles et schématiques, de structures obtenues à des étapes d'un autre mode de mise en oeuvre d'un procédé de fabrication d'une variante du dispositif optoélectronique 11 représenté en figure 1A.

Plus particulièrement, la figure 17 illustre une structure 89 obtenue à l'issue d'une étape de formation de tranchées 91 dans la structure 61 illustrée en figure 11. Les tranchées 91 peuvent être formées simultanément aux tranchées 63.

Les tranchées 91 s'étendent, de préférence, depuis la face supérieure de la structure 89 dans la structure 89. Les tranchées 91 s'étendent, de préférence, à travers le circuit MOS 33, la sous-couche 175 et la sous-couche 173 de sorte à découvrir la couche 29 dans les ouvertures 261. Les tranchées 91 ont, de préférence, en vue de dessus les mêmes dimensions et la même forme que les dimensions et la forme des ouvertures 261. En d'autres termes, lors de cette étape, les couches sus-jacentes à la couche 29 sont retirées à l'aplomb des ouvertures 261.

La figure 18 illustre une structure 93 obtenue à l'issue d'une étape de dépôt d'une couche isolante 95 et d'une étape de formation de régions conductrices 97 sur la face supérieure de la structure 93.

La couche isolante 95 est, de préférence, une couche en dioxyde de silicium. La couche isolante 95 est, de préférence, déposée par PECVD sur une épaisseur de l'ordre de 1 µm. Des ouvertures 99 sont ensuite gravées dans la couche isolante 95. La structure 93 comprend, de préférence, au moins une ouverture 99 de chaque côté de la tranchée 63. Les ouvertures 99 ont, par exemple, chacune une largeur l7 supérieure à 3 µm.

Les régions métalliques 97 sont, de préférence, en aluminium, en cuivre ou en une combinaison ou un alliage de ces deux matériaux. Les régions métalliques 97 peuvent avoir une structure monocouche ou une structure multicouche. Les régions 97 sont, de préférence, formées de façon à s'étendre dans les ouvertures 99. Les régions 97 sont formées, de préférence, sur une largeur l8 supérieure à 10 µm.

Les régions 97 sont, de préférence, connectées à des pistes métalliques du circuit MOS 33 de façon similaire, par exemple de façon analogue à ce qui a été décrit précédemment en relation avec la figure 13.

A l'issue de cette étape, des connecteurs (non représentés en figure 18), similaires aux connecteurs 41 illustrés en figure 15, sont formés sur et en contact avec les régions 97.

Un avantage des modes de réalisation et des modes de mise en oeuvre décrits est qu'ils permettent de coller le circuit logique 15 et le circuit optoélectronique 13 à des températures plutôt faibles (c'est-à-dire inférieures à 250 °C) ce qui limite les risques d'endommagement des matériaux composant le circuit optoélectronique.

Un autre avantage des modes de réalisation et des modes de mise en oeuvre décrits est qu'ils permettent d'augmenter la fiabilité du collage du circuit logique 15 et du circuit optoélectronique 13 en comparaison, par exemple, à un collage hybride, à base de plots de contact.

Encore un autre avantage des modes de réalisation et des modes de mise en oeuvre décrits est qu'ils permettent l'assemblage du substrat des diodes électroluminescentes et du substrat des circuits de commandes avec des contraintes de précision de positionnement moindres que pour un collage hybride.

Encore un autre avantage des modes de réalisation et des modes de mise en oeuvre décrits est que, par rapport au document US10468452, il n'y a pas de contraintes sur la connexion électrique entre les circuits 15 et 13.

Encore un autre avantage des modes de réalisation et des modes de mise en oeuvre décrits est qu'ils permettent de maximiser la surface utile de la LED formée sur une même surface de croissance.

Encore un autre avantage des modes de réalisation et des modes de mise en oeuvre décrits est qu'ils permettent de limiter les risques d'endommagement du substrat 27 étant donné que la tranchée d'isolation 391 ne s'étend pas jusqu'au substrat 27.

Un avantage des modes de réalisation et des modes de mise en oeuvre décrits est qu'ils sont compatibles avec les lignes de production usuelles des composants en microélectronique.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, dans les modes de réalisation décrits précédemment, pour pouvoir réaliser le collage moléculaire de la sous-couche 173 à la sous-couche 175, la planéité de la face 13s de la sous-couche 173 est obtenue par une éventuelle étape de planarisation effectuée après le dépôt de la sous-couche 173 et la planéité la face 15i de la sous-couche 175 est obtenue par une éventuelle étape de planarisation effectuée après le dépôt de la sous-couche 175. A titre de variante, la planéité de la face 13s de la sous-couche 173 peut être obtenue par le dépôt, avant la formation de la sous-couche 173, d'une couche de planarisation isolante électriquement, par exemple un oxyde, sur la structure sous-jacente, par la formation de vias traversants cette couche isolante de planarisation (par le dépôt d'un conducteur dans les vias traversant cette couche isolante de planarisation, et par la planarisation de ce matériau conducteur au même niveau que la couche isolante de planarisation), puis par le dépôt de la sous-couche 173 sur la couche de planarisation et au contact des vias, la sous-couche 173 ayant alors directement les propriétés de planéité recherchées. La formation de la couche isolante de planarisation peut comprendre le dépôt d'au moins une couche isolante suivi d'étape de planarisation, par exemple par CMP. De façon analogue, la planéité de la face 15i de la sous-couche 175 peut être obtenue par le dépôt, avant la formation de la sous-couche 175, d'une couche de planarisation isolante électriquement, par exemple un oxyde, sur la structure sous-jacente, par la formation de vias traversants cette couche isolante de planarisation (par le dépôt d'un conducteur dans les vias traversant cette couche isolante de planarisation, et par la planarisation de ce matériau conducteur au même niveau que la couche isolante de planarisation), puis par le dépôt de la sous-couche 175 sur la couche de planarisation et au contact des vias, la sous-couche 175 ayant alors directement les propriétés de planéité recherchées. L'obtention de la planéité de la face 13s de la sous-couche 173 par le dépôt d'une couche de planarisation isolante électriquement permet de faciliter le collage plaque à plaque et ainsi d'optimiser le temps de fabrication du dispositif optoélectronique. En outre, cela permet de réduire l'épaisseur du dispositif optoélectronique.

Enfin, la mise en oeuvre pratique des modes de réalisation et variantes décrits est à la portée de la personne du métier à partir des indications fonctionnelles données ci-dessus.

## Revendications

1. Dispositif optoélectronique (11) comportant un empilement :
d'un premier circuit (13) comprenant au moins une diode électroluminescente (LED) inorganique émettant par une première face (13i) du premier circuit et comprenant des première et deuxième électrodes (23, 24) ; et
d'un deuxième circuit (15) de commande de la diode électroluminescente, positionné sur une deuxième face (13s) du premier circuit opposée à la première face, comprenant des premier et deuxième plots conducteurs électriquement (31),
dans lequel une couche conductrice électriquement (17), comprenant la superposition d'une première sous-couche conductrice électriquement (173) du premier circuit (13) et d'une deuxième sous-couche conductrice électriquement (175) du deuxième circuit (15), est située à l'interface entre les premier et deuxième circuits, la couche conductrice électriquement (17) étant divisée en des première et deuxième parties orthogonalement à la direction d'empilement des premier et deuxième circuits,
la première électrode étant reliée électriquement au premier plot conducteur par l'intermédiaire de la première partie de la couche conductrice et la deuxième électrode étant reliée électriquement au deuxième plot conducteur par l'intermédiaire de la deuxième partie de la couche conductrice,
les première et deuxième parties de la couche conductrice (17) étant séparées par une tranchée d'isolation électrique (391).

2. Dispositif selon la revendication 1, comprenant au moins deux connecteurs (41), situés sur le deuxième circuit (15), du côté opposé au premier circuit (13), destinés à relier électriquement le dispositif (11) à un objet extérieur.

3. Dispositif selon la revendication 1 ou 2, dans lequel les premier et deuxième plots (31) conducteurs sont séparés par ladite tranchée d'isolation électrique (391).

4. Dispositif selon l'une quelconque des revendications 1 à 3, dans lequel le deuxième circuit (15) comprend des transistors à effet de champ à grille métal oxyde et comprend deux parties séparées électriquement par ladite tranchée d'isolation électrique (391).

5. Dispositif selon la revendication 4, dans lequel les parties du deuxième circuit (15) sont reliées électriquement par des connexions par des pistes conductrices électriquement (35) situées du côté des transistors à effet de champ à grille métal oxyde opposé au premier circuit (13).

6. Dispositif selon l'une quelconque des revendications 1 à 5, dans lequel la tranchée d'isolation électrique (391) a une forme fermée, dans un plan parallèle à la deuxième face (13s), ou dans lequel la tranchée d'isolation électrique (391) a, dans un plan parallèle à la deuxième face (13s), une forme ouverte dont les deux extrémités libres débouchent sur un ou des côtés du dispositif (11).

7. Dispositif selon l'une quelconque des revendications 1 à 6, dans lequel le premier circuit (13) comprend un substrat (27) du côté de la première face (13i), le substrat (27) pouvant être notamment en saphir ou en verre.

8. Dispositif selon l'une quelconque des revendications 1 à 7, dans lequel la couche conductrice (17) est en métal ou en un polymère conducteur.

9. Procédé de fabrication d'une pluralité de dispositifs optoélectroniques selon l'une quelconque des revendications 1 à 8, comprenant une étape a) d'assemblage d'une première plaque comprenant ladite pluralité de premiers circuits (13) à une deuxième plaque comprenant ladite pluralité de deuxièmes circuits (15).

10. Procédé selon la revendication 9, dans lequel l'étape
a) d'assemblage est réalisée par mise en contact, pleine plaque, des première et deuxième sous-couches (173, 175) de la couche conductrice électriquement (17).

11. Procédé selon la revendication 9 ou 10, dans lequel chaque premier circuit (13) est partiellement gravé dans une étape b) antérieure à l'étape a) de sorte à définir une première cavité (281) située à l'emplacement de la deuxième électrode.

12. Procédé selon l'une quelconque des revendications 9 à 11, dans lequel chaque premier circuit (13) est partiellement gravé dans une étape b') antérieure à l'étape a) de façon à réaliser une deuxième cavité (261) permettant de définir les bords de ladite diode électroluminescente (LED) .

13. Procédé selon la revendication 11 ou 12, comprenant une étape c), entre les étapes a) et b) ou b'), dans laquelle chaque diode électroluminescente (LED) est recouverte, du côté de la deuxième face du premier circuit (13), d'une couche diélectrique (29) ouverte au niveau des première et deuxième électrodes (23, 24).

14. Procédé selon la revendication 13, dans lequel entre l'étape c) et l'étape a), chaque diode électroluminescente (LED) est recouverte, du côté de la deuxième face du premier circuit (13), de la première sous-couche conductrice (173).

15. Procédé selon la revendication 14, dans lequel chaque deuxième circuit (15) est recouvert, avant l'étape a), de la deuxième sous-couche conductrice (175).

16. Procédé selon la revendication 15, dans lequel l'étape
a) d'assemblage est réalisée par un collage non hybride de la première sous-couche conductrice (173) avec la deuxième sous-couche conductrice (175).

17. Procédé selon l'une quelconque des revendications 9 à 16, lequel l'étape a) est suivie d'une étape d) de gravure, pour chaque dispositif optoélectronique (11), d'une tranchée (63) s'étendant dans la deuxième plaque (15) et dans la couche conductrice électriquement (17) jusqu'à la couche diélectrique (29).

18. Procédé selon la revendication 17, dans lequel l'étape
d) est suivie d'une étape de remplissage de la tranchée (63) en un matériau isolant afin de réaliser la tranchée d'isolation électrique (391).

## Patentansprüche

1. Optoelektronische Vorrichtung (11) aufweisend einen Stapel:
aus einer ersten Schaltung (13) mit mindestens einer anorganischen Leuchtdiode (LED), die durch eine erste Oberfläche (13i) der ersten Schaltung hindurch emittiert und erste und zweite Elektroden (23, 24) aufweist; und
aus einer zweiten Schaltung (15) zum Steuern der Leuchtdiode, die auf einer zweiten Oberfläche (13s) der ersten Schaltung gegenüber der ersten Oberfläche angeordnet ist, und die erste und zweite elektrisch leitende Kontaktflächen (31) aufweist,
wobei eine elektrisch leitende Schicht (17), die die Überlagerung einer ersten elektrisch leitenden Teilschicht (173) der ersten Schaltung (13) und einer zweiten elektrisch leitenden Teilschicht (175) der zweiten Schaltung (15) aufweist, an der Schnittstelle zwischen der ersten und der zweiten Schaltung angeordnet ist, wobei die elektrisch leitende Schicht (17) in einen ersten und einen zweiten Abschnitt orthogonal zur Stapelungsrichtung der ersten und zweiten Schaltung unterteilt ist,
wobei die erste Elektrode über den ersten Teil der leitenden Schicht elektrisch mit der ersten leitenden Kontaktfläche verbunden ist und die zweite Elektrode über den zweiten Teil der leitenden Schicht elektrisch mit der zweiten leitenden Kontaktfläche verbunden ist,
wobei die ersten und zweiten leitenden Teile der elektrisch leitenden Schicht (17) durch einen elektrisch isolierenden Graben (391) getrennt sind.

2. Vorrichtung nach Anspruch 1, mit mindestens zwei Anschlüssen (41), die sich auf dem zweiten Stromkreis (15) auf der dem ersten Stromkreis (13) entgegengesetzten Seite angeordnet sind und dazu bestimmt sind, die Vorrichtung (11) mit einem externen Objekt elektrisch zu verbinden.

3. Vorrichtung nach Anspruch 1 oder 2, wobei die ersten und zweiten leitenden Kontaktflächen (31) durch den elektrisch isolierenden Graben (391) getrennt sind.

4. Vorrichtung nach einem der Ansprüche 1 bis 3, wobei die zweite Schaltung (15) Metalloxid-Gate-Feldeffekttransistoren aufweist und zwei durch den elektrisch isolierenden Graben (391) elektrisch getrennte Abschnitte aufweist.

5. Vorrichtung nach Anspruch 4, wobei die Abschnitte der zweiten Schaltung (15) durch Verbindungen über elektrisch leitende Bahnen (35) elektrisch gekoppelt sind, die sich auf der Seite der Metalloxid-Gate-Feldeffekttransistoren befinden, die entgegengesetzt zur ersten Schaltung (13) liegt.

6. Vorrichtung nach einem der Ansprüche 1 bis 5, wobei der elektrisch isolierende Graben (391) in einer Ebene parallel zur zweiten Oberfläche (13s) eine geschlossene Form aufweist, oder wobei der elektrisch isolierende Graben (391) in einer Ebene parallel zur zweiten Oberfläche (13s) eine offene Form aufweist, deren zwei freie Enden in eine oder mehrere der Seiten der Vorrichtung (11) münden.

7. Vorrichtung nach einem der Ansprüche 1 bis 6, wobei die erste Schaltung (13) auf der Seite der ersten Oberfläche (13i) ein Substrat (27) aufweist, wobei das Substrat (27) insbesondere aus Saphir oder aus Glas hergestellt sein kann.

8. Vorrichtung nach einem der Ansprüche 1 bis 7, wobei die leitfähige Schicht (17) aus Metall oder aus einem leitfähigen Polymer hergestellt ist.

9. Verfahren zur Herstellung einer Vielzahl von optoelektronischen Vorrichtungen nach einem der Ansprüche 1 bis 8, aufweisend einen Schritt a) des Anbringens eines ersten Wafers, der die Vielzahl von ersten Schaltungen (13) aufweist, mit einem zweiten Wafer, der die Vielzahl von zweiten Schaltungen (15) aufweist.

10. Verfahren nach Anspruch 9, wobei der Zusammenbauschritt a) durch vollflächiges Inkontaktbringen von ersten und zweiten Teilschichten (173, 175) der elektrisch leitenden Schicht (17) durchgeführt wird.

11. Verfahren nach Anspruch 9 oder 10, wobei jede erste Schaltung (13) in einem Schritt b) vor dem Schritt a) teilweise geätzt wird, um einen ersten Hohlraum (281) zu definieren, der sich an der Stelle der zweiten Elektrode befindet.

12. Verfahren nach einem der Ansprüche 9 bis 11, wobei jede erste Schaltung (13) in einem Schritt b') vor dem Schritt a) teilweise geätzt wird, um einen zweiten Hohlraum (261) zu bilden, der es ermöglicht, die Ränder der lichtemittierenden Diode (LED) zu definieren.

13. Verfahren nach Anspruch 11 oder 12, aufweisend einen Schritt c) zwischen den Schritten a) und b) oder b'), bei dem jede Leuchtdiode (LED) auf der Seite der zweiten Oberfläche der ersten Schaltung (13) mit einer dielektrischen Schicht (29) bedeckt wird, die auf der Höhe der ersten und zweiten Elektroden (23, 24) offen ist.

14. Verfahren nach Anspruch 13, wobei zwischen Schritt c) und Schritt a) jede Leuchtdiode (LED) auf der Seite der zweiten Oberfläche der ersten Schaltung (13) mit der ersten leitenden Teilschicht (173) bedeckt wird.

15. Verfahren nach Anspruch 14, wobei jede zweite Schaltung (15) vor dem Schritt a) mit der zweiten leitenden Teilschicht (175) bedeckt wird.

16. Verfahren nach Anspruch 15, wobei der Anbringungsschritt a) durch ein nicht hybrides Verbinden der ersten leitenden Teilschicht (173) mit der zweiten leitenden Teilschicht (175) durchgeführt wird.

17. Verfahren nach einem der Ansprüche 9 bis 16, wobei sich an den Schritt a) ein Schritt d) des Ätzens, für jede optoelektronische Vorrichtung (11), eines Grabens (63) anschließt, der sich in dem zweiten Wafer (15) und in der elektrisch leitenden Schicht (17) bis zur dielektrischen Schicht (29) erstreckt.

18. Verfahren nach Anspruch 17, wobei sich an dem Schritt d) ein Schritt des Füllens des Grabens (63) mit einem Isoliermaterial anschließt, um den elektrisch isolierenden Graben (391) herzustellen.

## Claims

1. Optoelectronic device (11) comprising a stack:
of a first circuit (13) comprising at least one inorganic light-emitting diode (LED) emitting through a first surface (13i) of the first circuit and comprising first and second electrodes (23, 24); and
of a second circuit (15) for controlling the light-emitting diode, positioned on a second surface (13s) of the first circuit opposite to the first surface, comprising first and second electrically-conductive pads (31),
wherein an electrically-conductive layer (17) comprising the stacking of a first electrically-conductive sub-layer (173) of the first circuit (13) and of a second electrically-conductive sub-layer (175) of the second circuit (15), is located at the interface between the first and second circuits, the electrically-conductive layer (17) being divided into first and second portions orthogonally to the stacking direction of the first and second circuits,
the first electrode being electrically coupled to the first conductive pad via the first portion of the conductive layer and the second electrode being electrically coupled to the second conductive pad via the second portion of the conductive layer,
the first and second conductive portions of the electrically-conductive layer (17) being separated by an electrical insulation trench (391).

2. Device according to claim 1, comprising at least two connectors (41), located on the second circuit (15), on the side opposite to the first circuit (13), intended to electrically couple the device (11) to an external object.

3. Device according to claim 1 or 2, wherein the first and second conductive pads (31) are separated by said electrical insulation trench (391).

4. Device according to any of claims 1 to 3, wherein the second circuit (15) comprises metal oxide gate field-effect transistors and comprises two portions electrically separated by said electrical insulation trench (391).

5. Device according to claim 4, wherein the portions of the second circuit (15) are electrically coupled by connections by electrically-conductive tracks (35) located on the side of the metal oxide gate field-effect transistors opposite to the first circuit (13).

6. Device according to any of claims 1 to 5, wherein the electrical insulation trench (391) has a closed shape, in a plane parallel to the second surface (13s), or wherein the electrical insulation trench (391) has, in a plane parallel to the second surface (13s), an open shape having its two free ends emerging onto one or a plurality of the sides of the device (11).

7. Device according to any of claims 1 to 6, wherein the first circuit (13) comprises a substrate (27) on the side of the first surface (13i), wherein the substrate (27) can in particular be made of sapphire or of glass.

8. Device according to any of claims 1 to 7, wherein the conductive layer (17) is made of metal or of a conductive polymer.

9. Method of manufacturing a plurality of optoelectronic devices according to any of claims 1 to 8, comprising a step a) of assembly of a first wafer comprising said plurality of first circuits (13) to a second wafer comprising said plurality of second circuits (15).

10. Method according to claim 9, wherein assembly step a) is carried out by placing into contact, full plate, first and second sub-layers (173, 175) of the electrically-conductive layer (17).

11. Method according to claim 9 or 10, wherein each first circuit (13) is partially etched at a step b) prior to step a) to define a first cavity (281) located at the location of the second electrode.

12. Method according to any of claims 9 to 11, wherein each first circuit (13) is partially etched at a step b') prior to step a) to form a second cavity (261) enabling to define the edges of said light-emitting diode (LED).

13. Method according to claim 11 or 12, comprising a step c), between steps a) and b) or b'), where each light-emitting diode (LED) is covered, on the side of the second surface of the first circuit (13), with a dielectric layer (29) open at the level of the first and second electrodes (23, 24).

14. Method according to claim 13, wherein between step c) and step a), each light-emitting diode (LED) is covered, on the side of the second surface of the first circuit (13), with the first conductive sub-layer (173).

15. Method according to claim 14, wherein each second circuit (15) is covered, before step a), with the second conductive sub-layer (175).

16. Method according to claim 15, wherein assembly step a) is carried out by a non-hybrid bonding of the first conductive sub-layer (173) with the second conductive sub-layer (175).

17. Method according to any of claims 9 to 16, wherein step a) is followed by a step d) of etching, for each optoelectronic device (11), of a trench (63) extending in the second wafer (15) and in the electrically-conductive layer (17) all the way to the dielectric layer (29).

18. Method according to claim 17, wherein step d) is followed by a step of filling of the trench (63) with an insulating material to manufacture the electrical insulation trench (391).
